# EUROPÄISCHE PATENTSCHRIFT

(11) **EP 0 884 786 B1**
(45) Veröffentlichungstag und Bekanntmachung des Hinweises auf die Patenterteilung: **03.05.2006**
(21) Anmeldenummer: 98105553.6
(22) Anmeldetag: 26.03.1998
(51) Int. Cl.: G09F 9/33, F21S 8/00

(54) **Anzeigeanordnung**
Display apparatus
Dispositif d'affichage

(30) Priorität: 09.06.1997 DE 29710027 U
(43) Veröffentlichungstag der Anmeldung: 16.12.1998
(73) Patentinhaber: Ernst Bremicker GmbH & Co. KG, 82362 Weilheim (DE)
(72) Erfinder: Bettendorf, Anton, Ernst Bremicker GmbH & Co. KG, 82362 Weilheim (DE); Dopfer, Herbert, Ernst Bremicker GmbH & Co. KG, 82362 Weilheim (DE)
(74) Vertreter: Baronetzky, Klaus

(56) Entgegenhaltungen:
- BE-A- 891 622
- DE-U- 9 016 695
- FR-A- 2 352 359
- FR-A- 2 551 242
- GB-A- 2 280 534
- US-A- 3 918 053

## Beschreibung

Die Erfindung betrifft eine Anzeigeanordnung gemäß dem Oberbegriff von Anspuch 1.

Derartige Anzeigeanordnungen zur Bereitstellung von Anzeigen über eine Mehrzahl in einer bestimmten Weise angeordneter und separat oder in Gruppen schaltbarer Leuchtdioden sind in verschiedenen Ausgestaltungen bekannt geworden. Beispielsweise werden sog. Siebensegment-Anzeigen fertig konfektioniert und mit Decoderschaltkreisen kombiniert angeboten, die die Bereitstellung von Ziffernanzeigen ermöglichen.

Aus Gründen der besseren Herstellbarkeit im Verhältnis zur Lichtausbeute sind die bekannten Anzeigeanordnungen häufig mit roten Leuchtdioden im Spektralbereich von etwa 650 nm bestückt, wobei hinzukommt, daß die Farbe rot vergleichsweise gut sichtbar ist, wenn Fremdlichteinfälle zu berücksichtigen sind.

Um die Sichtbarkeit bei Fremdlicht zu verbessern, ist es bekannt geworden, in der Farbe des Emissionsspektrums getönte Scheiben zu verwenden und den Leuchtdioden oder LEDs zuzuordnen, wobei die Lichtemission dann durch die getönte Scheibe erfolgt.

Ferner ist es bekannt geworden, daß Anzeigeanordnungen in verschiedenen Weisen - teilweise auch in Verbindung oder vergossen mit einer Schutzscheibe oder diese durchtretend - montiert werden können. Beispielsweise sind entsprechende Fassungen für LEDs bekannt geworden, die eine Passform für den meist runden Kunststoffkörper der LED aufweisen und mit denen eine eingerastete und rasche Montage der LED in einer Frontplatte möglich ist.

Insbesondere bei Lichtzeichen, die im Schienen- und Straßenverkehr verwendet werden können, ist neben der Fremdlichtstabilität auch die Zuverlässigkeit und insbesondere die Witterungs- und Verschmutzungsunanfälligkeit einer Anzeigeanordnung relevant. Daneben besteht die Notwendigkeit, eine gute Sichtbarkeit mit einer Seitenablesbarkeit zu verbinden, die eine Erkennbarkeit der durch Einschalten der betreffenden LEDs in Gruppen erzeugten Lichtsignale auch bei einem Ablesewinkel von beispielsweise 35° ohne weiteres ermöglichen.

Um eine besonders hohe Helligkeit zu erzielen, ist es bekannt geworden, eine zentrale Lichtquelle, die beispielsweise als Halogen- oder gar als Quecksilberdampflampe ausgebildet sein kann, mit Lichtleitern wie Glasfaserkabeln zu bestücken und je nach Bestückung der Anzeigeanordnung die Glasfasern zu Bündeln zusammengefaßt an einer Anzeigescheibe enden zu lassen. Ein weiteres Beispiel für eine derartige Anzeigeanordnung ist aus der DE 195 14 498 A1 zu entnehmen.

GB2280534 offenbart eine Anzeigeanordnung mit einer Mehrzahl nebeneinander angeordneter Leuchtdioden die in einer Scheibe abgestützt sind, wobei jede Leuchtdioden mit ihrem Kragen an der rückwärtigen Fläche der Scheibe anliegt.

Andererseits sind Halogen- und Quecksilberdampflampen vergleichsweise teuer und haben eine zumindest gegenüber LEDs geringere Lebensdauer, so daß sicherheitshalber die Lampen vergleichsweise häufig ausgetauscht werden, um ein Durchbrennen und damit einen Ausfall der Lichtzeichenanlage sicher auszuschließen.

Demgegenüber liegt der Erfindung die Aufgabe zugrunde, eine Anzeigeanordnung insbesondere für den Schienen- und Straßenverkehr gemäß dem Oberbegriff von Anspruch 1 zu schaffen, die hinsichtlich der Lebensdauer gegenüber bekannten Anzeigeanordnungen verbessert ist und dennoch eine besonders gute Lichtausbeute mit einer guten Seitenablesbarkeit verbindet.

Diese Aufgabe wird erfindungsgemäß durch Anspruch 1 gelöst. Vorteilhafte Weiterbildungen ergeben sich aus den Unteransprüchen.

Überraschend ergibt die erfindungsgemäße Ausgestaltung der Anzeigeanordnung eine besonders gute Sichtbarkeit bei der Zentralablesung und eine ausreichende Erkennbarkeit auch bei Seitenablesung beispielsweise in einem Ablesewinkel von 45°. Zudem ist die Herstellung und Montage der erfindungsgemäßen Anzeigeanordnung besonders einfach und schnell möglich, indem die für die Aufnahme der LED vorgesehenen Sacklöcher mit bekannten Mehrfachbohrern erstellt werden.

Alternativ kommt es auch in Betracht, die Sacklöcher durch Warmumformung der aus thermoplastischen Material bestehenden Scheibe herzustellen.

Besonders ist erfindungsgemäß vorgesehen, daß eine LED mit einem Sichtwinkel von weniger als 10°, bevorzugt von etwa 8°, verwendet wird, die in das konisch endende Sackloch eingesteckt ist. Durch den geringen Sichtwinkel wird erfindungsgemäß eine besonders gute Hellichkeit von mind. 4000 mcd bereitgestellt, die durch die im Frontbereich der LED weniger als 1 mm dünne Scheibe trotz der Verwendung von Schwarz/Weiß-Scheiben nur unwesentlich, beispielsweise um 10%, reduziert wird.

Dennoch ergibt sich eine flache Vorderfläche, die verschmutzungs- und witterungsunempfindlich und ggf. leicht abwaschbar ist.

Überraschend führt die erfindungsgemäße Anordnung mit der höchstens als Kreislinienanlage vorgesehenen Anlage zwischen der Vorderfläche des dort kalottenförmigen Kunststoffkörpers der LED dem Grund der Sacklochbohrung zu der erwünschten Verbesserung der Seitenablesbarkeit, ohne die zentrale Lichtemission hoher Intensität zu beeinträchtigen. Dies bedeutet, daß die sich in dem Kunststoffkörper zwangsläufig diffus ausbreitenden Restlichtteile optimal für die Emission zur Verbesserung der Seitenablesbarkeit ausgenutzt werden, ohne die zentrale Emission zu beeinträchtigen.

Durch die Anlage eines Kunststoffkörpers in dessen rückwärtigen Bereich an dem Umfang des Sacklochs ist eine sichere Montage möglich, wobei dennoch eine seitliche Lichteinleitung in die Erstreckung der Scheibe praktisch ausgeschlossen ist, besonders, wenn der Diodenchip, der in dem Kunststoffkörper vergossen ist, etwa auf der Höhe der rückwärtigen Fläche der Scheibe angeordnet ist.

Grundsätzlich kann die Scheibe hinsichtlich ihrer Stärke in weiten Bereichen an die Erfordernisse angepaßt werden. Die Stärke ist jedoch so gewäht, daß der Kragen der LED noch etwas aus der rückwärtigen Fläche der Scheibe hervorsteht, so daß der LED chip etwa auf der Höhe dieser Fläche angeordnet ist. Diese Anordnung führt überraschend zu der erfindungsgemäß besonders guten Lichtemission.

Gemäß einer vorteilhaften Ausgestaltung ist es vorgesehen, daß die Scheibe mit ihrer Vorderfläche matt ausgebildet ist. Diese Ausgestaltung vermindert die Reflexion von Fremdlicht auf der Vorderfläche der Scheibe, was insbesondere dann relevant ist, wenn die Scheibe direkter Sonneneinstrahlung ausgesetzt ist.

Während bevorzugt eine Spitzsenkung des Sacklochs vorgesehen ist, wobei der Konuswinkel etwa 120° beträgt, versteht es sich, daß je nach Bedarf auch eine andere Ausgestaltung des Sacklochgrundes möglich ist, beispielsweise auch ein flacher Sacklochgrund oder ein Sacklochgrund mit einem Radius, der vergleichsweise groß ist und bis zum Radius der Kalotte des Kunststoffkörpers reduziert werden kann.

Trotz der lediglich 1 mm dünnen Vorderfläche, die sogar auf noch geringere Werte reduziert werden kann, ist speziell bei der konusförmigen Ausbildung des Sacklochgrundes eine Beschädigung dieses Bereichs nicht zu befürchten. Zum einen wird dieser Haupt-Lichtdurchtrittsbereich durch die umgebenden Bereiche der Scheibe gut abgestützt. Zum anderen wirkt auch der Kunststoffkörper der LED über die Kreislinienauflage stabilisierend.

Gemäß einer besonders bevorzugten Ausgestaltung der Erfindung ist eine Leuchtdiode mit einer maximalen Helligkeit von etwa 5000 mcd vorgesehen, die einen Sichtwinkel von 8° ergibt. Bei Einbau in die erfindungsgemäße Anzeigeanordnung ergibt sich eine zwar etwas verminderte Maximalhelligkeit, wobei sich jedoch dennoch eine ausreichende seitliche Ablesbarkeit erzielen läßt.

Weitere Einzelheiten, Vorteile und Merkmale ergeben sich aus der nachstehenden Beschreibung eines Ausführungsbeispiels anhand der Zeichnung. Es zeigen:
- Fig. 1: eine Ansicht eines Sichtwinkeldiagramms einer Leuchtdiode in eine erfindungsgemäße Anzeigenanordnung; und
- Fig. 2: eine Ansicht einer in eine erfindungsgemäße Anzeigenanordnung eingebaute Leuchtdiode.

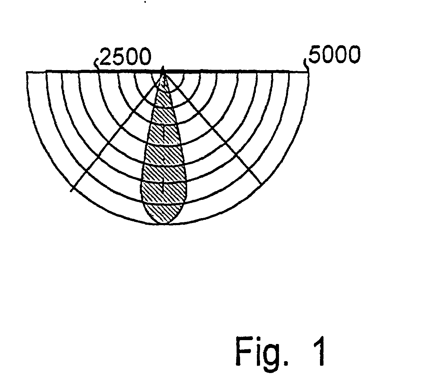

Das in Fig. 1 dargestellte Diagramm zeigt, daß sich der Sichtwinkel der Leuchtdiode über einen vergleichsweise schmalen Bereich erstreckt. Beim gemäß Normung vorgesehenen Schwellenwert von 50 %, also 2500 mcd, erstreckt sich der Sichtwinkel über 8°, und der Schwellenwert bei 4500 mcd beträgt etwa 6°.

Durch die erfindungsgemäße Montage dieser Leuchtdiode in der Scheibe ergibt sich zwar eine leicht reduzierte Maximalhelligkeit, wobei tatsächlich jedoch das Streulicht der Seitenflanken weiter für die Verbesserung der Seitenablesbarkeit verwendet wird, ohne die Maximalhelligkeit allzu stark zu reduzieren.

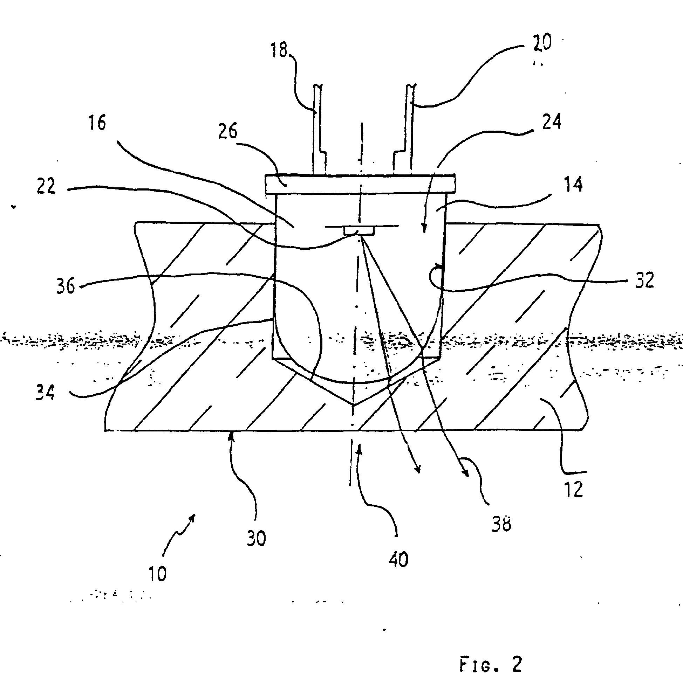

Aus Fig. 2 ist die beispielhafte Anordnung einer Leuchtdiode in der erfindungsgemäßen Anzeigeanordnung dargestellt. Es versteht sich, daß zahlreiche Leuchtdioden entsprechend der in Fig. 2 dargestellten Leuchtdiode übereinander und nebeneinander angeordnet sind, die bevorzugt in Gruppen schaltbar sind.

Die Anzeigeanordnung 10 weist eine Scheibe 12 und eine Vielzahl von Leuchtdioden auf, von denen eine Leuchtdiode 14 in Fig. 1 dargestellt ist. Die Leuchtdiode 14 weist einen Kunststoffkörper 16 und in an sich bekannter Weise Anschlußdrähte 18 und 20 auf, die aus dem Kunststoffkörper 16 heraustreten.

In den Kunststoffkörper 16 ist ferner der Diodenchip 22 eingebettet, der Licht in dem vorgesehenen Spektralbereich emittiert. Bevorzugt erfolgt die Lichtemission im Bereich von entweder 645 nm (rot) oder 590 nm (gelb) oder 520 nm (grün). Die Leuchtdiode 14 ist in einem Sackloch 24 der Scheibe 12 eingesteckt, wobei sie mit ihrem Kragen 26 deutlich aus der Rückfläche 28 der Scheibe 12 hervorsteht. Sie durchtritt jedoch nicht die Scheibe 12, so daß die mattierte Vorderfläche 30 der Scheibe auch im Bereich der Leuchtdiode 14 glatt ist.

Das Sackloch 24 weist einen Umfang auf, der dem Umfang des Kunststoffkörpers 16 entspricht. Dementsprechend ist die Leuchtdiode 14 in das Sackloch 24 eingepaßt und liegt mit ihrer Umfangswand 32 an der entsprechenden Ringwand 34 des Sacklochs an.

Das Sackloch 24 weist einen Sacklochgrund 36 auf, der im dargestellten Ausführungsbeispiel konusförmig ist. Die Leuchtdiode 14 endet vorne in einer Halbkugel oder.Kalotte des Kunststoffkörpers 16, die das aus dem Diodenchip austretende Licht 38 im Grund bündelt. An den Grenzen zwischen dem Kunststoffkörper 16, Luft oder der Vergußmasse einerseits, sowie der Scheibe 12 und der Umgebungsluft andererseits erfolgt eine Lichtbrechung, wobei es besonders günstig ist, wenn die beispielsweise als Schwarz/Weiß-Scheibe ausgebildete Scheibe 12 einen Brechungsindex hat, der in etwa dem Brechungsindex des Kunststoffkörpers 16 entspricht und beispielsweise bei 1,3 liegt.

Die Anlage zwischen dem Sacklochgrund 36 und dem Kunststoffkörper 16 ist höchstens entlang einer Kreisring- oder Linienauflage vorgesehen, um die erfindungsgemäße Lichtemission zu erzielen. Es versteht sich, daß der Emissionswinkel durch die Einstecktiefe der Leuchtdiode 14 in das Sackloch 24 bedingt ist.

Wesentlich ist ferner, daß der Zentralbereich 40 der Lichtemission nicht durch eine zu dicke Scheibe 12 beeinträchtigt wird. In dem dargestellten Ausführungsbeispiel ist bei einer Dicke des Kunststoffkörpers 16 von 5 mm eine Dicke der Scheibe 12 an der Spitze des Sacklochgrundes 36 von ca. 0,6 mm vorgesehen. Aufgrund der konischen Ausbildung des Sacklochgrundes 36 wird dieser Bereich gut abgestützt.

Es versteht sich, daß die erfindungsgemäße Anzeigeanordnung gewünschtenfalls an die Anforderungen hinsichtlich der Lichttechnik anpassbar ist. So kann beispielsweise anstelle des konischen Sacklochgrundes auch ein flacher oder mit einem Radius versehener Sacklochgrund vorgesehen sein. Besonders günstig ist es fernerhin, daß durch die Sicht auf eine zusätzliche Frontscheibe die Entstehung eines Phantombildes sicher verhindert wird.

Dadurch, daß keine Linsen des Kunststoffkörpers 16 gegenüber der Scheibe 12 vorstehen und dadurch die Vorderfläche 30 völlig flach ist, ergibt sich die Möglichkeit, die Scheibe 12 bei Verschmutzung leicht zu reinigen. Besonders günstig ist es ferner, daß eine Acrylglasscheibe mit Schwarzpartikeln verwendet werden kann, die die Lichtemission in Längsrichtung der Scheibe weitgehend verhindert.

## Patentansprüche

1. Anzeigeanordnung, mit einer Mehrzahl nebeneinader angeordneter und je separat oder in Gruppen schaltbarer Leuchtdioden (14), die in einer Scheibe (12) abgestützt sind, wobei der Lichtaustritt der Leuchtdioden (14) durch die Scheibe (12) verläuft und jede Leuchtdiode (14) einen in einem Kunststoffkörper (16) eingebetteten lichtaussendenden Diodenchip (22) aufweist und mit ihrem Umfang an einem Sacklock (24) der Scheibe (12) anliegt, in welche sie von hinten eingesteckt ist, und mit ihrer Stirnfläche an dem Sacklochgrund (36) der Scheibe (12) anliegt, und zwar höchstens entlang einer Kreislinie, und mit ihrem Kragen (26) aus der rückwärtigen Fläche (28) der Scheibe (12) hervorsteht.

2. Anzeigeanordnung nach Anspruch 1, **dadurch gekennzeichnet, daß** die Leuchtdiode (14) einen Lichtaustrittswinkel von weniger als 20°, bevorzugt von etwa 8°, aufweist.

3. Anzeigeanordnung nach einem der vorhergehenden Ansprüche, **dadurch gekennzeichnet, daß** das Sackloch (24) in einem Innenkonus endet, der einen Konuswinkel von mehr als 90°, insbesondere von etwa 120°, aufweist.

4. Anzeigeanordnung nach einem der vorhergehenden Ansprüche, **dadurch gekennzeichnet, daß** die Anlage zwischen der Ringwand (34) Umfang der Sacklochbohrung (24) und dem Kunststoffkörper (16) der Diode sich über etwa die halbe Länge des Kunststoffkörpers (16), insbesondere über 30 bis 70 Prozent und bevorzugt über 45 Prozent, erstreckt.

5. Anzeigeanordnung nach einem der vorhergehenden Ansprüche, **dadurch gekennzeichnet, daß** die minimale verbleibende Wandstärke der getönten Scheibe im Zentalbereich (40) des Lichtaustritts weniger als 1 mm und insbesondere etwa 0,6 mm beträgt.

6. Anzeigeanordnung nach einem der vorhergehenden Ansprüche, **dadurch gekennzeichnet, daß** das Sackloch (24) zwischen dem Kunststoffkörper (16) und der Scheibe (12) mit einer durchsichtigen Masse vergossen ist.

## Claims

1. Display arrangement with a majority of light emitting diodes (14) arranged side by side and each able to be switched separately or in groups, which are supported in a disc (12), where the light emission of the light emitting diodes (14) passes through the disc (12) and each light emitting diode (14) comprises a light emitting diode chip (22) embedded in a plastic body (16) and with its perimeter sits close against a blind hole (24) on the disc (12), into which it is inserted from the rear, and with its front surface sits close against the base of the blind hole (36) of the disk (12), at most along a circumference, and with its collar (26) projects from the rear surface (28) of the disk (12).

2. Display arrangement according to claim 1, **characterized in that** the light emitting diode (14) comprises an angle of light emission of less than 20°, preferably of approximately 8°.

3. Display arrangement according to one of the preceding claims, **characterized in that** the blind hole (24) ends in an interior cone, which comprises a coning angle greater than 90°, preferably approximately 120°.

4. Display arrangement according to one of the preceding claims, **characterized in that** the arrangement between the ring wall (34), perimeter of the blind hole bore (24) and the plastic body (16) of the diode extends along approximately half the length of the plastic body (16), preferably along 30 to 70 per cent and in particular along 45 per cent.

5. Display arrangement according to one of the preceding claims, **characterized in that** the minimal remaining wall thickness of the tinted disk in the central area (40) of the light emission amounts to less than 1 mm and preferably about 0.6 mm.

6. Display arrangement according to one of the preceding requirements, **characterized by** the fact that the blind hole (24) is sealed with a transparent mass between the plastic body (16) and the disk (12).

## Revendications

1. Disposition d'affichage avec une majorité de diodes électroluminescentes (14) disposéés côte à côte et commutable soit séparément soit par groupe, qui sont soutenues dans un disque (12), où l'émission de la lumière des diodes électroluminescentes (14) passe à travers le disque (12) et chaque diode électroluminescente (14) présente une puce de diode (22) émettant de la lumière encastré dans un corps de matièère plastique (16) et colle avec son volume à un trou borgne (24) du disque (12), dans lequel elle est insérée par derrière, et avec sa face avant colle au fond du trou borgne (36) du disque (12), et ceci, tout au plus le long d'une circonférence, et avec son collier (26) se projette hors de la surface (28) arrière du disque (12).

2. Disposition d'affichage selon la revendication 1, **caractérisée en ce que** la diode électroluminescente (14) présente un angle d'émission de lumière de moins de 20°, de préférence d'environ 8°.

3. Disposition d'affichage selon l'une des revendications précédentes, **caractérisée en ce que** le trou borgne (24) finit en cône intérieur, qui présente un angle de cône de plus de 90 °, de préférence d'environ 120°.

4. Disposition d'affichage selon l'une des revendications précédentes, **caractérisée en ce que** la disposition s'étend entre la paroi d'anneau (34), le volume de la forure du trou borgne (24) et le corps de matière plastique (16) de la diode sur environ la demi-longueur du corps de matière plastique (16), de préférence sur 30 à 70 pour cent et de préférence plus de 45 pour cent.

5. Disposition d'affichage selon l'une des revendications précédentes, **caractérisée en ce que** l'épaisseur minimale restante de paroi du disque teint dans le secteur central (40) de l'émission de la lumière est moins de 1 mm et de préférence environ 0,6 mm.

6. Disposition d'affichage selon l'une des revendications précédentes, **caractérisée en ce que** le trou de sac (24) est scellé entre le corps de matière plastique (16) et le disque (12) avec une masse transparente.
